# EUROPÄISCHE PATENTANMELDUNG

(11) **EP 4 447 230 A1**
(43) Veröffentlichungstag der Anmeldung: **16.10.2024**
(21) Anmeldenummer: 24168430.7
(22) Anmeldetag: 04.04.2024
(51) Int. Cl.: H01R 12/58, H05B 1/00, H01R 4/48, H01R 12/71, H01R 12/73

(54) **LEITUNGSWEG UND ELEKTRISCHE HEIZVORRICHTUNG MIT EINEM LEITUNGSWEG**

(30) Priorität: 13.04.2023 DE 102023109279
(71) Anmelder: Eberspächer catem GmbH & Co. KG, 76863 Herxheim (DE)
(72) Erfinder: Niederer, Michael, 76889 Kapellen-Drusweiler (DE)
(74) Vertreter: Grünecker Patent- und Rechtsanwälte PartG mbB

(57) **Zusammenfassung**

Die Erfindung betrifft einen Leitungsweg (47) für Leistungsstrom oder Steuersignale, insbesondere einer elektrischen Heizvorrichtung (1), wobei in dem Leitungsweg (47) mindestens eine Leiterplatte (90, 86, 88), eine elektrisch mit der Leiterplatte (90, 86, 88) verbundene Kontaktfeder (48) und ein Kontaktstift (49) vorgesehen ist, der mit der Kontaktfeder (48) steckkontaktiert ist. Die Kontaktfeder (48) ist mit einem ersten Federarm (52) und einem zweiten Federarm (54) ausgebildet, die einen Aufnahmebereich (60) der Kontaktfeder (48) bilden, in dem der Kontaktstift (49) zumindest teilweise aufgenommen ist, wobei durch die Aufnahme des Kontaktstiftes (49) im Aufnahmebereich (60) eine elektrische Verbindung zwischen Kontaktfeder (48) und Kontaktstift (49) und eine mechanische Fixierung des Kontaktstiftes (49) in der Kontaktfeder (48) erreicht wird, wobei der Kontaktstift (49) eine Längsachse (66) aufweist, wobei die Kontaktfeder (48) in Richtung der Längsachse (66) und in einer ersten Montagerichtung (62) senkrecht zur Längsachse (66) offen ausgebildet ist, wobei die Federarme (52, 54) zur Fixierung des Kontaktstifts (49) vorgespannt ausgebildet sind, wobei die Kontaktfeder (48) an einem ersten Element (82) und der Kontaktstift (49) an einem zweiten Element (84) ausgebildet ist, wobei das erste Element (82) und das zweite Element (84) in mindestens einer spezifischen Konstellation verwirklicht sind.

## Beschreibung

Die vorliegende Erfindung betrifft einen Leitungsweg, insbesondere für eine elektrische Heizvorrichtung, insbesondere zum Einsatz in Kraftfahrzeugen. Der Leitungsweg umfasst eine Leiterplatte und eine Kontaktfeder, die mit der Leiterplatte mechanisch und elektrisch verbunden ist, sowie einen Kontaktstift, der mit der Kontaktfeder steckkontaktiert und damit daran mechanisch fixiert und elektrisch verbunden ist, sowie eine entsprechende elektrische Heizvorrichtung.

Aus der EP 2 236 330 A1 ist ein Aufbau der elektrischen Heizvorrichtung bekannt, bei der in dem Leitungsweg zu zumindest einem elektrischen Heizelement in Form eines PTC-Elemente eine Leiterplatte und eine mit der Leiterplatte mechanisch und elektrisch verbundene Kontaktfeder mit Kontaktzungen vorgesehen ist. Die Kontaktfeder ist mit einem in die Kontaktfeder quer zu der Erstreckung der Leiterplatte hineinragenden Kontaktstift elektrisch steckkontaktiert ist, der zwischen die einander gegenüberliegenden Kontaktzungen gebracht wird.

Beim Aufbau der elektrischen Heizvorrichtung sind verschiedene Elemente elektrisch miteinander zu verbinden, beispielsweise eine Kontaktierungseinrichtung, die mehrere Heizelemente der Heizvorrichtung zu einem Heizkreis gruppiert, oder die Kontaktierungseinrichtung mit einer Leiterplatte einer Steuerungseinrichtung zur Versorgung der Heizelemente mit Leistungsstrom, eine Leiterplatte der Steuerungseinrichtung mit einem Leistungsstromstecker zur Versorgung der Leiterplatte bzw. der Steuerungseinrichtung mit Leistungsstrom, eine Leiterplatte der Steuerungseinrichtung mit einem Steuerstecker zur Übertragung von elektrischen Steuersignalen an die Steuerungseinrichtung. Jede dieser Verbindungen kann in dem Leitungsweg liegen oder diesen ausbilden.

Der vorliegenden Erfindung liegt das Problem zugrunde, eine Lösung anzugeben, die eine vereinfachte elektrische Verbindung zwischen Elementen im Leitungsweg, insbesondere einer elektrischen Heizvorrichtung ermöglicht.

Zur Lösung dieses Problems wird ein Leitungsweg für Leistungsstrom oder Steuersignale in einem Gehäuse vorgeschlagen, wobei in dem Leitungsweg mindestens eine Leiterplatte, eine elektrisch mit der Leiterplatte verbundene Kontaktfeder und ein Kontaktstift vorgesehen ist, der mit der Kontaktfeder steckkontaktiert ist. Der Leitungsweg kann in einer elektrischen Heizeinrichtung vorgesehen sein, die mindestens eine elektrische Heizeinrichtung, insbesondere eine PTC-Heizeinrichtung mit mindestens einem PTC-Element, und eine mehrere Heizeinrichtungen einer elektrischen Heizvorrichtung zu einem Heizkreis gruppierende Kontaktierungseinrichtung umfasst, wobei die Heizeinrichtung mit der Kontaktierungseinrichtung und die Kontaktierungseinrichtung mit einer Steuerungseinrichtung umfassend mindestens eine Leiterplatte elektrisch verbunden sein kann.

Die erfindungsgemäße Lösung zeichnet sich dadurch aus, dass mindestens eine Kontaktfeder mit einem ersten Federarm und einem zweiten Federarm ausgebildet ist, die einen Aufnahmebereich der Kontaktfeder bilden, in dem ein Kontaktstift zumindest teilweise aufgenommen ist, wobei durch die Aufnahme des Kontaktstiftes im Aufnahmebereich eine elektrische Verbindung zwischen Kontaktfeder und Kontaktstift und eine mechanische Fixierung des Kontaktstiftes in der Kontaktfeder erreicht wird, wobei der Kontaktstift eine Längsachse aufweist, wobei die Kontaktfeder in Richtung der Längsachse und in einer ersten Montagerichtung senkrecht zur Längsachse und zur Leiterplatte offen ausgebildet ist, wobei die Federarme zur Fixierung des Kontaktstifts vorgespannt ausgebildet sind, wobei die Kontaktfeder an einem ersten Element und der Kontaktstift an einem zweiten Element ausgebildet ist, wobei das erste Element und das zweite Element in mindestens einer der folgenden Konstellationen ausgebildet sind:
a. das erste Element ist eine erste Leiterplatte und das zweite Element ist eine zweite Leiterplatte;
b. das erste Element ist eine Leiterplatte und das zweite Element ist ein Stecker;
c. das erste Element ist eine Leiterplatte und das zweite Element ist die Kontaktierungseinrichtung; und
d. das erste Element ist die Kontaktierungseinrichtung und das zweite Element eine Leiterplatte:

Bevorzugt ist der Leitungsweg Teil einer entsprechenden elektrischen Heizvorrichtung zum Aufheizen eines flüssigen Mediums, bevorzugt umfassend Wasser. Die elektrische Heizvorrichtung ist bevorzugt in einem Kraftfahrzeug eingesetzt zum Aufheizen des flüssigen Mediums. Der Leitungsweg nach der vorliegenden Erfindung weist mindestens einmal die Konstellation a., mindestens einmal die Konstellation b., mindestens einmal die Konstellation c. und/oder mindestens einmal die Konstellation d. auf.

Die Ausbildung eines elektrischen Leitungsweges für Leistungsstrom oder Steuersignale in einer elektrischen Heizvorrichtung nach der vorliegenden Erfindung ermöglicht die elektrische und mechanische Verbindung zweier Elemente der elektrischen Heizvorrichtung über eine Kontaktfeder mit zwei Federarmen, die einen Aufnahmebereich für einen Kontaktstift bilden, der durch die vorgespannten Federarme mit einer vorgebbaren Haltekraft in der Kontaktfeder fixiert ist. Hierbei kann es sich bei dem ersten Element um eine erste Leiterplatte und bei dem zweiten Element um eine zweite Leiterplatte handeln, die insbesondere Teil einer im Gehäuse der elektrischen Heizvorrichtung ausgebildeten Steuerungseinrichtung ist. Eine Leiterplatte im Sinne dieses Dokumentes kann jede Leiterplatte sein, unabhängig davon, ob sie mit Bauelementen bestückt ist oder lediglich Leiterbahnen zur Leitung von Strom zwischen zwei Punkten umfasst.

Alternativ oder zusätzlich ist das erste Element eine Leiterplatte und das zweite Element ein Stecker. So kann die hier beschriebene Kontaktierungstechnik aus einer Kontaktfeder und einem Kontaktstift zur Ausbildung einer Verbindung eines Leistungs- oder Steuersteckers und einer entsprechenden Aufnahme in einer Leiterplatte der Steuerungseinrichtung eingesetzt werden.

Der Kontaktstift ist in der Regel ein längliches einheitliches Bauteil aus einem gut elektrisch leitendem Vollmaterial wie Kupfer oder einer Kupferlegierung, bevorzugt mit runden Querschnitt. Der Kontaktstift hat bevorzugt zumindest einen zylindrischen Abschnitt, in dem sich der Außendurchmesser und die äußere Form des Kontaktstifts nicht ändert. Der Kontaktstift kann mit einem elektrisch hochwertigen Material wie Gold, Silber oder einer Legierung dieser Materialien beschichtet sein.

Alternativ oder zusätzlich ist das erste Element eine Leiterplatte und das zweite Element ist die Kontaktierungseinrichtung. Alternativ oder zusätzlich ist das erste Element die Kontaktierungseinrichtung und das zweite Element eine Leiterplatte. So kann insbesondere die Ausbildung der elektrischen Verbindung zwischen der Kontaktierungseinrichtung und einer Leiterplatte der Steuerungseinrichtung ausgebildet werden.

Unter einer offenen Ausbildung der Kontaktfeder in Richtung der Längsachse wird verstanden, dass die Kontaktfeder so gestaltet ist, dass der Kontaktstift in Richtung der Längsachse in die Kontaktfeder einschiebbar ist und insbesondere keine Bauteile vorhanden sind, die in Richtung der Längsachse den Aufnahmebereich für den Kontaktstift zumindest teilweise verschließen. Unter einer offenen Ausbildung der Kontaktfeder in der ersten Montagerichtung wird verstanden, dass die Kontaktfeder so ausgebildet ist, dass der Kontaktstift in der ersten Montagerichtung in die Kontaktfeder einbringbar ist und insbesondere, dass keine Bauteile ausgebildet sind, die den Aufnahmebereich in der ersten Montagerichtung zumindest teilweise verschließen.

Bevorzugt weist jeder Federarm mindestens einen Kontaktbereich auf, dessen Form zur Form einer Kontaktfläche des Kontaktstiftes korrespondieren. Bevorzugt ist zumindest ein Teil der Kontaktbereiche durch den Kontaktstift gespannt und presst mit einer definierten Kraft an die Kontaktfläche des Kontaktstiftes, um einen definierten elektrischen Kontakt zwischen Kontaktbereich und Kontaktfläche zu bilden.

Durch die Ausbildung des Kontaktstiftes und der Kontaktfeder, in die der Kontaktstift in zwei Montagerichtungen einbringbar ist, sind kompakt bauende Verbindungen in einer elektrischen Heizvorrichtung der eingangs genannten Art möglich. Die Anbindung der genannten Elemente ist so wesentlich flexibler möglich. Gleichzeitig ist eine flexible Montage des Kontaktstifts möglich, da zwischen zwei Montagerichtungen gewählt werden kann. Die hier vorgeschlagene Verbindung über eine Kontaktfeder ermöglicht die Ausbildung definierter Kontaktbereiche oder auch -punkte zur Leistungsstrom- oder Steuersignalübertragung. Die Kontaktfeder kann in Abhängigkeit von den zu übertragenen Leistungsströmen entsprechend in ihrer Länge in Längsrichtung angepasst und mit größeren Kontaktbereichen und/oder entsprechend in Größe und Anzahl angepassten Kontaktvorsprüngen oder Kontaktpunkten versehen werden. Die Montage ist einfach, da keine Lötverbindung zwischen Kontaktstift und Kontaktfeder erfolgen muss, sondern lediglich die Kontaktfeder mit dem entsprechenden Element verbunden, insbesondere verlötet werden muss.

Gemäß einer bevorzugten Weiterbildung der vorliegenden Erfindung weist die Kontaktfeder einen Führungsbereich auf, der sich entgegengesetzt zur ersten Montagerichtung vom Aufnahmebereich weg erstreckt, der sich in Richtung auf den Aufnahmebereich zur Führung des Kontaktstiftes bei Einführung des Kontaktstiftes in der ersten Montagerichtung verjüngt. Der Führungsbereich erleichtert die Montage des Kontaktstiftes in der ersten Montagerichtung. Bevorzugt ist der Führungsbereich durch einen oder zwei Führungsabschnitte, die an einem oder beiden Federarmen der Kontaktfeder ausgebildet sind, definiert.

Gemäß einer bevorzugten Weiterbildung der vorliegenden Erfindung ist die Kontaktfeder mit dem ersten Element verlötet. Hierdurch ist es möglich, die Kontaktfeder einfach und automatisiert an dem ersten Element zu befestigen. Gleichzeitig wird so auf einfache Art und Weise eine Leitungsweg zwischen dem ersten Element und dem zweiten Element über Kontaktfeder und Kontaktstift ausgebildet.

Gemäß einer bevorzugten Weiterbildung der Erfindung weist die Kontaktfeder mindestens einen Haltesteg auf, der in eine entsprechende Ausnehmung des ersten Elementes eingreift. Hierdurch ist eine einfache Montage der Kontaktfeder am ersten Element möglich. Gleichzeitig kann durch Ausbildung einer Lötverbindung zwischen Haltesteg und Ausnehmung eine elektrische Verbindung zwischen Kontaktfeder und beispielsweise einer Leiterbahn im ersten Element erfolgen. Bevorzugt weist die Ausnehmung hierzu eine metallische Beschichtung, bevorzugt mit einer Kupferlegierung oder Kupfer auf. Bevorzugt weist die Kontaktfeder mindestens zwei Haltestege auf, die in entsprechende Ausnehmungen des ersten Elementes eingreifen und die bevorzugt durch eine Lötverbindung miteinander verbunden sind. Durch die Anbindung der Kontaktfeder an zwei Punkten können auftretende Biegemomente aufgenommen werden.

Gemäß einer bevorzugten Weiterbildung der Erfindung ist der Kontaktbereich rotationssymmetrisch zur Längsachse ausgebildet. Dies ermöglicht eine einfache Fertigung des Kontaktstiftes und erleichtert die Montage, da bei der Montage des Kontaktstiftes es zwar auf die Positionierung des Kontaktstiftes relativ zur Kontaktfeder ankommt, nicht aber auf die Orientierung des Kontaktbereichs relativ zur Kontaktfeder.

Gemäß einer bevorzugten Weiterbildung der Erfindung weist der Kontaktstift in Richtung der Längsachse an einem Ende einen sich verjüngenden Einführbereich auf. Durch den sich verjüngenden Endbereich ist die Montage des Kontaktstiftes in der zweiten Montagerichtung vereinfacht, da durch den sich verjüngenden Endbereich eine einfache Einführung und Zentrierung des Kontaktstiftes in der Kontaktfeder möglich ist.

Gemäß einer bevorzugten Weiterbildung der Erfindung sind an den Federarmen und insbesondere in den Kontaktbereichen der Federarme Kontaktvorsprünge ausgebildet sind, die an der Kontaktfläche des Kontaktstiftes anliegen. Die Kontaktvorsprünge bilden insbesondere Kontaktpunkte zur elektrischen Kontaktierung des Kontaktstiftes.

Weiterhin wird eine elektrische Heizvorrichtung mit mindestens einem Leitungsweg nach der vorliegenden Erfindung vorgeschlagen.

Die vorliegende Erfindung betrifft insbesondere einen Leitungsweg einer elektrischen Heizvorrichtung, bevorzugt einer elektrischen Heizvorrichtung mit zumindest einem elektrischen Heizelement, beispielsweise zumindest einem PTC-Element, wie sie beispielsweise aus EP 1 872 986 A1 und der EP 2 236 330 A1 bekannt ist. Eine solche elektrische Heizvorrichtung umfasst üblicherweise ein Gehäuse mit einer Trennwand, die eine Anschlusskammer von einer Heizkammer zur Abgabe von Wärme an ein zu erwärmendes Medium trennt. Von dieser kann zumindest ein Heizeinrichtungsgehäuse in Richtung auf die Heizkammer abragen und oder wärmleitend daran anliegt. Das Heizeinrichtungsgehäuse kann eine Aufnahmetasche ausbilden, in der zumindest ein PTC-Element und elektrisch leitend mit diesem verbundene Leiterbahnen, die üblicherweise in eine Leiterplatte integriert sind, vorgesehen sind, die in der Anschlusskammer elektrisch angeschlossen sind. Die Leiterbahnen dienen der Bestromung des PTC-Elementes mit unterschiedlicher Polarität. So wird der Leistungsstrom zum Betrieb des PTC-Elementes über die Anschlusskammer dem PTC-Element zugeleitet.

Bevorzugt ist das PTC-Element elektrisch leitend mit einer Leiterplatte verbunden, wobei das PTC-Element mindestens eine Kontaktzunge aufweist, die zur elektrischen und mechanischen Verbindung eine entsprechende Ausnehmung einer Leiterplatte der Steuerungseinrichtung oder einer Kontaktierungseinrichtung durchtritt. Alternativ oder zusätzlich ist es auch bevorzugt, dass das PTC-Element einen Kontaktstift aufweist, der mit einer Kontaktfeder der Leiterplatte wie in diesem Dokument beschrieben mechanisch und elektrisch leitend verbunden ist

Die Heizeinrichtung kann aber auch durch eine andere elektrische Heizeinrichtung als eine PTC- Heizeinrichtung gebildet sein, so beispielsweise eine Dickschichtheizung.

Weitere Einzelheiten und Vorteile der vorliegenden Erfindung ergeben sich aus der nachfolgenden Beschreibung eines Ausführungsbeispiels in Verbindung mit der Zeichnung. In dieser zeigen:
- Figur 1 und 2:: perspektivische Ansichten eines Beispiels einer elektrischen Heizvorrichtung;
- Figur 3:: eine Schnittansicht eines Teils des Beispiels einer elektrischen Heizvorrichtung;
- Figur 4:: ein Detail eines Beispiels einer elektrischen Heizvorrichtung im Schnitt;
- Figur 5:: eine perspektivische Darstellung eines Ausschnitts des Beispiels einer elektrischen Heizvorrichtung;
- Figur 6:: eine Stirnseitenansicht eines montierten Kontaktstifts nach Figur 4 und
- Figur 7: eine perspektivische Ansicht eines Beispiels einer Kontaktfeder.

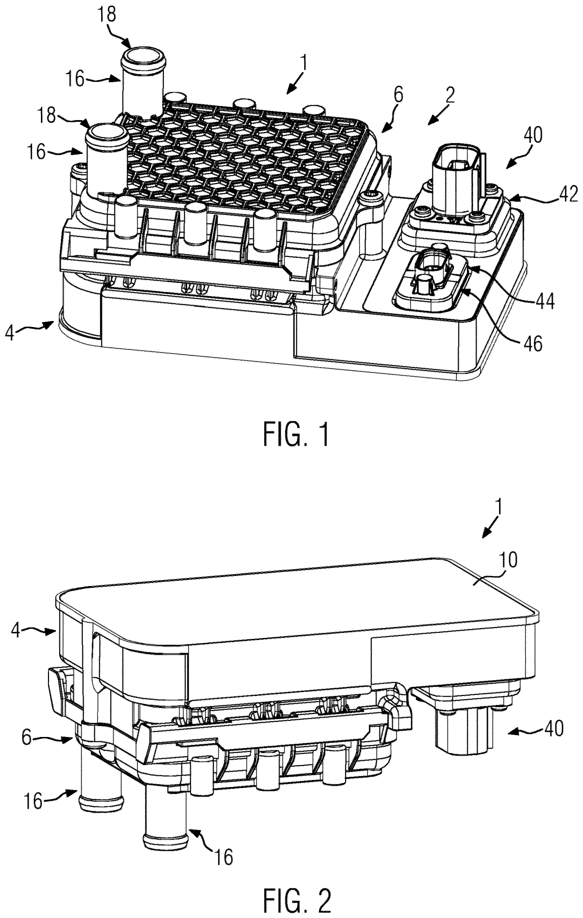

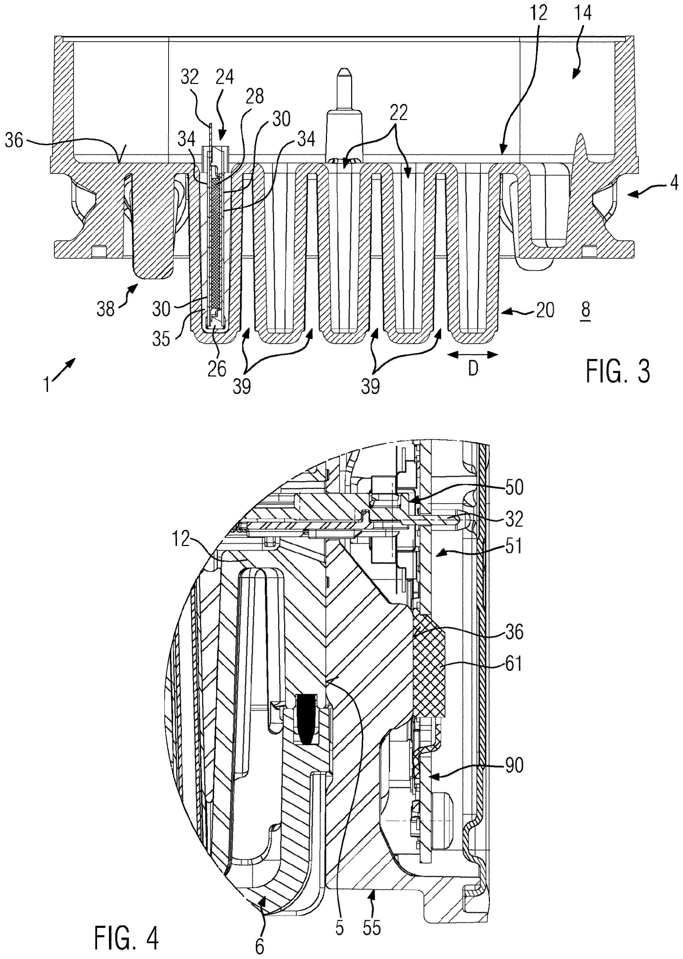

Die Figuren 1 bis 3 zeigen ein Beispiel einer elektrischen Heizvorrichtung 1 mit einem insgesamt mit Bezugszeichen 2 gekennzeichneten Gehäuse. Figur 4 zeigt ein Detail eines Beispiels der elektrischen Heizvorrichtung 1. Das Gehäuse 2 hat ein Gehäuseoberteil 4 aus Metall, ein Gehäuseunterteil 6 aus Kunststoff, welches dicht zur Ausformung einer Heizkammer 8 mit dem Gehäuseoberteil 4 verbunden ist, und einen Gehäusedeckel 10, der fluiddicht mit dem Gehäuseoberteil 4 verbunden ist. Die Heizkammer 8 ist in Figur 3 mit Bezugszeichen 8 gekennzeichnet, wenngleich das Gehäuseunterteil 6 dort nicht dargestellt ist. Zwischen dem Gehäusedeckel 10 und einer mit Bezugszeichen 12 gekennzeichneten Trennwand bildet das Gehäuseoberteil 4 eine Anschlusskammer 14 aus. Die Trennwand 12 trennt die Anschlusskammer 14 von der Heizkammer 8 ab.

Das Gehäuseunterteil 6 bildet einteilig daran angeformte Einlass- und Auslassstutzen 16 aus. Diese Stutzen 16 bilden Ein- bzw. Auslassöffnungen 18 zu der Heizkammer 8. An diese Stutzen 16 können Schläuche zum Führen des zu erwärmenden flüssigen Mediums, insbesondere Wasser, gegebenenfalls mit Additiven, angeschlossen werden.

Die Stutzen 16 münden in die Heizkammer 8. In diese Heizkammer 8 ragen Heizeinrichtungsgehäuse 20 hinein, die durch Druckguss einteilig an der Trennwand 12 und damit dem Gehäuseoberteil 4 ausgebildet sind.

Jedes Heizeinrichtungsgehäuse 20 bildet eine in Figur 3 mit Bezugszeichen 22 gekennzeichnete Aufnahmetasche aus, die zu der Heizkammer 8 hin geschlossen und zu der Anschlusskammer 14 hin offen ist. Wie Figur 3 zeigt, ist in jeder Aufnahmetasche 22 vorliegend zumindest eine ggf. auch mehrere PTC-Heizeinrichtungen 24 vorgesehen. Jede PTC-Heizeinrichtung 24 hat einen Rahmen 26, der ein PTC-Element 28 in sich aufnimmt und zwei Leiterbahnen in Form von Kontaktblechen 30 zu einer Einheit fügt, die unmittelbar elektrisch leitend an Hauptseitenflächen des PTC-Elementes 28 anliegen und bis in die Anschlusskammer 14 hineinragende Kontaktzungen 32 ausbilden. Die Kontaktbleche 30 sind außenseitig mit einer Isolierlage 34, beispielsweise einer Aluminiumoxidplatte bzw. einer elektrisch isolierenden Folie, versehen. Dadurch werden die Kontaktbleche 30 isolierend in der Aufnahmetasche 22 abgestützt. Ein gut wärmeleitender Kontakt der Hauptseitenflächen des PTC-Elementes 28 kann beispielsweise durch Verkeilen des PTC-Elementes 28 zusammen mit den Kontaktblechen und den Isolierlagen 34 in der Aufnahmetasche 22 durch ein U-förmiges Element 35 erfolgen; vergleiche DE 10 2020 201 571 A1.

In Figur 3 ist seitlich neben den Aufnahmetaschen 22 eine Kühlfläche 36 erkennbar, die durch die Trennwand 12 ausgebildet ist und gegen welche Leistungsschalter einer in dieser Figur nicht dargestellten Steuerungseinrichtung wärmeleitend angelegt sind. Details der Steuerungseinrichtung sind in Figur 4 offenbart. Der Kühlfläche 36 ist zumindest eine einteilig an der Trennwand vorgesehene Kühlrippe 38 zugeordnet. Zwischen benachbarten Heizeinrichtungsgehäusen 20 bzw. zwischen einem Heizeinrichtungsgehäuse 20 und der Kühlrippe 38 werden Strömungskanäle 39 ausgebildet.

Die Figuren 1 und 2 lassen einen Leistungsstecker 40 mit einem Leistungssteckergehäuse 42 und einen Steuerstecker 44 mit einem Steuersteckergehäuse 46 erkennen. Über diese Schnittstellen wird der Leistungsstrom bzw. werden die Steuersignale der in der Anschlusskammer oder in einem gesonderten Steuergehäuse vorgesehenen Steuerungseinrichtung zugeleitet.

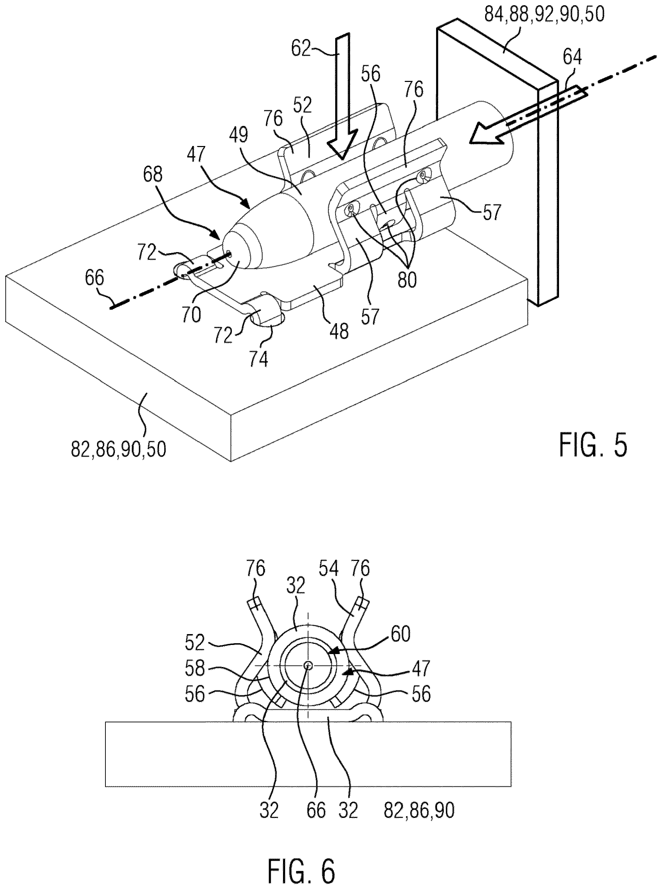

Figur 4 zeigt eine Schnittansicht eines Details eines Beispiels einer elektrischen Heizvorrichtung 1. Bei diesem Beispiel ist eine Steuerungseinrichtung 51 in einem gesonderten metallischen Steuergehäuse 55 vorgesehen. Alternativ ist es möglich, dass die Steuerungseinrichtung 51 in der Anschlusskammer 14 ausgebildet ist. Die elektrische Verbindung der PTC-Heizeinrichtungen 24 mit der Steuerungseinrichtung 51 erfolgt über eine in der Anschlusskammer 14 angeordnete Kontaktierungseinrichtung 50, die dort mehrere PTC-Heizeinrichtungen 24 zu Heizkreisen gruppiert. Die Kontaktierungseinrichtung 50 als Verdrahtungsmodul ausgebildet sein mit einem elektrisch isolierenden Träger, der mehrere Stromschienen elektrisch voneinander isoliert abstützt- vgl. EP 2 626 647A1, EP 2 505 931 A1. Die Stromschienen der als Verdrahtungsmodul ausgebildeten Kontaktierungseinrichtung 50 sind mit der Leiterplatte 90 kontaktiert, insbesondere wie in Figur 5 und 6 gezeigt und unten beschrieben.

Die Steuerungseinrichtung 51 umfasst in diesem Beispiel im Wesentlichen eine bestückte Leiterplatte 90, mit welcher der Leistungsstecker 40 und der Steuerstecker 44 sowie die Kontaktierungseinrichtung 50 kontaktiert sind und die Leistungsschalter 61 aufweist, die wärmeleitend unter Zwischenlage einer elektrisch isolierenden Folie je an einer Kühlfläche 36 anliegen, die durch das Gehäuseunterteil 6 gebildet ist. Das Steuergehäuse 55 ist mit dem Gehäuseoberteil 4 verschweißt, verlötet bzw. verklebt. Dazu hat das Gehäuseoberteil 4 eine in Figur 4 mit Bezugszeichen 5 gekennzeichnete Außenfläche.

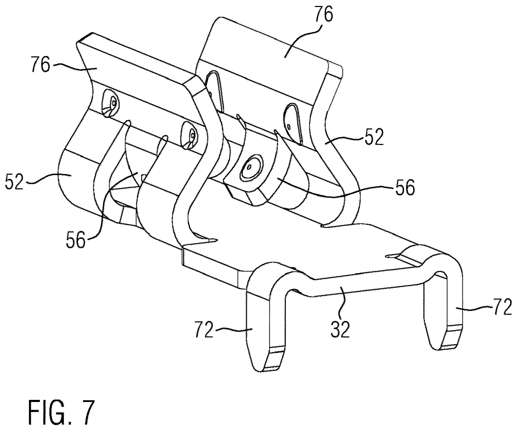

Mit Bezug auf die Figuren 5 bis 7 wird im Folgenden ein Leitungsweg 47 nach der vorliegenden Erfindung beschrieben, welcher in einer elektrischen Heizvorrichtung 1, beispielsweise wie in Fig. 1 bis 4 gezeigt, eingesetzt werden kann. Die Figuren 5 und 6 zeigen einen Teil des Beispiels einer elektrischen Heizvorrichtung 1 nach Figuren 1 bis 4. Sofern nicht im Folgenden auf eine gesondert Figur Bezug genommen wird, werden beide Figuren 5 und 6 gemeinsam beschrieben.

Die elektrische Heizvorrichtung 1 umfasst eine Vielzahl von elektrischen Verbindungen, beispielsweise für die Übermittlung von Leistungsstrom zum Betrieb der PTC-Elemente 28 oder für die Übermittlung von Steuersignalen zum Ansteuern einzelner Komponenten. Hierfür sind Leitungswege notwendig. Die Figuren 5 und 6 zeigen dabei ein Ausführungsbeispiel eines Leitungsweges 47.

Der Leitungsweg 47 umfasst dabei eine Kontaktfeder 48 mit einem ersten Federarm 52 und einem zweiten Federarm 54, die einen Aufnahmebereich 60 der Kontaktfeder 48 bilden, in dem ein Kontaktstift 49 zumindest teilweise aufgenommen ist, wobei durch die Aufnahme des Kontaktstiftes 49 im Aufnahmebereich 60 eine elektrische Verbindung zwischen Kontaktfeder 48 und Kontaktstift 49 und eine mechanische Fixierung des Kontaktstiftes 49 in der Kontaktfeder 48 erreicht wird. Der Kontaktstift 49 weist eine Längsachse 66 auf.

Die Kontaktfeder 48 ist in Richtung der Längsachse 66 und in einer ersten Montagerichtung 62 senkrecht zur Längsachse 66 und zur Leiterplatte 50 offen ausgebildet, wobei die Federarme 52, 54 zur Fixierung des Kontaktstifts 49 vorgespannt ausgebildet sind. Die Kontaktfeder 48 ist an einem ersten Element 82 und der Kontaktstift 49 an einem zweiten Element 84 ausgebildet. Hierbei ist insbesondere das zweite Element 84 sehr schematisch gezeichnet, es kann eine beliebige Form und Ausrichtung haben.

Es sind vier mögliche Konstellationen von erstem Element 82 und zweitem Element 84 nach der vorliegenden Erfindung vorgesehen. In einer elektrischen Heizvorrichtungen 1 kann eine dieser Konstellationen einfach oder mehrfach ausgebildet sein, jedoch auch eine Kombination zweier oder mehrerer Konstellationen. In einer ersten Konstellation (a.) ist das erste Element 82 eine erste Leiterplatte 86 und das zweite Element 84 ist eine zweite Leiterplatte 88. Die erste und die zweite Leiterplatte 86, 88 sind dabei bevorzugt Teil der Steuerungseinrichtung 51 der elektrischen Heizvorrichtung 1. In einer zweiten Konstellation (b.) ist das erste Element 82 eine Leiterplatte 90 und das zweite Element 84 ist ein Stecker 92. Der Stecker 92 ist bevorzugt zumindest Teil des Leistungssteckers 40. Der Stecker 92 ist bevorzugt zumindest Teil des Steuersteckers 44. Die Leiterplatte 90 ist bevorzugt Teil der Steuerungseinrichtung 51. In einer dritten Konstellation (c.) ist das erste Element 82 eine Leiterplatte 90 und das zweite Element 84 ist die Kontaktierungseinrichtung 50. Die Leiterplatte 90 ist bevorzugt Teil der Steuerungseinrichtung 51. In einer vierten Konstellation (d.) ist das erste Element die Kontaktierungseinrichtung 50 und das zweite Element 84eine Leiterplatte 90. Die Leiterplatte 90 ist bevorzugt Teil der Steuerungseinrichtung. 51

Der Kontaktstift 49 ist in der Kontaktfeder 48 mechanisch aufgenommen und elektrisch mit dieser verbunden. Die Kontaktfeder 48 ist an dem ersten Element 82 festgelegt.

Die Kontaktfeder 48 ist aus einem Federstahl, der mit einem elektrisch hochwertigen Material wie Gold, Silber oder einer Legierung dieser Materialien beschichtet sein kann, ausgebildet und weist einen ersten Federarm 52 und einen zweiten Federarm 54 auf. Die Federarme 52, 54 sind vorgespannt und können gegen die Vorspannung voneinander weg verschwenkt werden. Jeder Federarm 52, 54 umfasst einen ersten Kontaktbereich 56 und zweite Kontaktbereiche 57. Der erste Kontaktbereich 56 ist im vorliegenden Beispiel als eine Federzunge im jeweiligen Federarm 52, 54 ausgebildet. Der erste Kontaktbereich 56 wie auch jeder zweite Kontaktbereich 58 des Federarms 52, 54 weisen eine Form auf, die zur Außenkontur einer Kontaktfläche 58 des Kontaktstiftes 49 korrespondiert, so dass im montierten Zustand die Kontaktbereiche 56, 57 der Kontaktfeder 48 an der Kontaktfläche 58 des Kontaktstiftes 49 aufgrund der zylindrischen Gestaltung des Kontaktstiftes 49 und der korrespondierenden Krümmung der Kontaktbereiche 56, 58 flächig oder zumindest linienförmig anliegen. Der Kontaktstift 49 ist metallisch oder metallisch beschichtet ausgeführt, ebenso zumindest die Kontaktbereiche 56, 57 der Kontaktfeder 48, so dass durch diese Anlage einerseits eine mechanische Festlegung des Kontaktstiftes 49 in der Kontaktfeder 48 und andererseits eine elektrisch leitende Kontaktierung zwischen Kontaktstift 49 und Kontaktfeder 48 erreicht wird.

Die Kontaktbereiche 56, 57 der Federarme 52, 54 bilden zwischen sich einen Aufnahmebereich 60 (siehe insbesondere Fig. 6), in dem der Kontaktstift 49 im Bereich seiner Kontaktfläche 58 aufgenommen ist. Die Kontaktfläche 58 ist in diesem Beispiel zylindersymmetrisch ausgebildet. Die Montage des Kontaktstiftes 49 in die Kontaktfeder 48 kann durch Einschieben in eine erste Montagerichtung 62 oder durch Einschieben in eine zweite Montagerichtung 64 erfolgen. Beide Montagerichtungen 62, 64 sind in Fig. 5 durch Pfeile angedeutet. Die zweite Montagerichtung 64 ist dabei koaxial zur Längsachse 66 des Kontaktstiftes 49 ausgerichtet.

Im vorliegenden Beispiel ist der Kontaktstift 49 rotationssymmetrisch um die Längsachse 66 ausgebildet, wie insbesondere auch Fig. 6 zeigt, so dass die Kontaktfläche 58 eine Zylinderfläche um die Längsachse 66 bildet. An einem Ende 68 (vgl. insb. Fig. 5) ist der Kontaktstift 49 verjüngt unter Bildung eines verjüngten Endbereichs 70 ausgebildet. Die Kontaktfeder 48 weist Haltestege 72 auf, die in entsprechende Ausnehmungen 74 des ersten Elements 82 aufgenommen und mit diesen verlötet werden.

Zur Montage in der ersten Montagerichtung 62 wird der Kontaktstift 49 in erster Montagerichtung 62 über der Kontaktfeder 48 positioniert und dann in der ersten Montagerichtung 62 in die Kontaktfeder 48 gedrückt. Zur Zentrierung weisen die Federarme 52, 54 Führungsabschnitte 76 auf, die einen Führungsbereich 78 bilden. Der Führungsbereich 78 ist hin zu den Kontaktbereich 56 zulaufend ausgebildet, so dass die Kontaktfeder 48 in erster Montagerichtung 62 offen ist, also kein Element aufweist, welches den Aufnahmebereich 60 in dieser Richtung zumindest teilweise verschließt.

Die Federarme 52, 54 sind vorgespannt, der Kontaktstift 49 drückt bei der Montage in der ersten Montagerichtung 62 die Federarme 52, 54 auseinander, bis die Kontaktfläche 58 an den Kontaktbereichen 56 der Federarme 52, 54 anliegt. Durch die Vorspannung der Federarme 52, 54 wird der Kontaktstift 49 in der Kontaktfeder 48 festgelegt. Gleichzeitig wird eine elektrisch leitende Verbindung zwischen Kontaktstift 49 und Kontaktfeder 48 geschaffen, so dass der Leitungsweg 47 das erste Element 82, die Kontaktfeder 48;den Kontaktstift 49 und das zweite Element 84 verbindet und über den Leitungsweg 47 Leistungsstrom und/oder Steuersignale übertragbar sind. Hierzu ist die Kontaktfeder 48 über die Haltestege und die Ausnehmungen 74 elektrisch mit nicht gezeigten Leiterbahnen im ersten Element 82 verbunden.

Eine Montage in der zweiten Montagerichtung 64 wird durch dem verjüngten Endbereich 70 erleichtert. Zur Montage wird der Kontaktstift 48 in zweiter Montagerichtung 64 vor der Kontaktfeder 48 positioniert und dann in zweiter Montagerichtung 64 in den Aufnahmebereich 60 eingeschoben, so dass der verjüngte Endbereich 70 zuerst in den Aufnahmebereich 60 eindringt und so für eine Zentrierung sorgt. Durch den verjüngten Endbereich 70 werden die beiden Federarme 52, 54 auseinandergedrückt, bis die Kontaktfläche 58 an den Kontaktbereichen 56 der Federarme 52, 54 anliegt. Auch in der zweiten Montagerichtung 24 ist die Kontaktfeder 48 offen, weist also keine Elemente auf, die den Aufnahmebereich 60 in dieser Richtung zumindest teilweise verschließen. So bietet die vorliegende Erfindung verschiedene Möglichkeiten zur automatisierten Montage des Kontaktstiftes 49 in der Kontaktfeder 48.

Figur 6 zeigt eine perspektivische Ansicht einer noch nicht montierten Kontaktfeder 48 ohne montierten Kontaktstift 49. Die Kontaktfeder 48 wird aus einem Blech, insbesondere einem Stahlblech, bevorzugt einem Federstahlblech ausgebildet, insbesondere durch Stanzen und Umformen. Die Federarme 52, 54 sind vorgespannt. Die Haltestege 72 können in entsprechende Ausnehmungen 74 des ersten Elementes 82 eingebracht und mit diesen verlötet werden. Bevorzugt weist die Ausnehmung 74 hierzu eine elektrisch leitende Beschichtung auf. Bevorzugt ist die hier gezeigte Ausgestaltung der Kontaktfeder 48 mit zwei Haltestegen 72 über die einerseits eine redundante elektrische Verbindung mit nicht gezeigten Leiterbahnen in dem ersten Element 82 erreicht und andererseits eine mechanisch besser gegen Verdrehung gesicherte Verbindung mit dem ersten Element 82 erreicht wird. Über optionale Kontaktvorsprünge 80, die in den Federarmen 52, 54 und insbesondere auch in den Kontaktbereichen 56, 57 ausgebildet sind wird der elektrische Kontakt zwischen Kontaktfeder 48 und Kontaktstift 49 definiert in den durch die Kontaktvorsprünge 80 gebildeten Kontaktpunkten hergestellt.

### Bezugszeichenliste

- 1: elektrische Heizvorrichtung
- 2: Gehäuse
- 4: Gehäuseoberteil
- 5: Außenfläche
- 6: Gehäuseunterteil
- 8: Heizkammer
- 10: Gehäusedeckel
- 12: Trennwand
- 14: Anschlusskammer
- 16: Stutzen
- 18: Ein- bzw. Auslassöffnung
- 20: Heizeinrichtungsgehäuse
- 22: Aufnahmetasche
- 24: PTC-Heizeinrichtung
- 26: Rahmen
- 28: PTC-Element
- 30: Kontaktblech
- 32: Kontaktzunge
- 34: Isolierlage
- 35: U-förmiges Element
- 36: Kühlfläche
- 38: Kühlrippe
- 39: Strömungskanal
- 40: Leistungsstecker
- 42: Leistungssteckergehäuse
- 44: Steuerstecker
- 46: Steuersteckergehäuse
- 47: Leitungsweg
- 48: Kontaktfeder
- 49: Kontaktstift
- 50: Kontaktierungseinrichtung
- 51: Steuerungseinrichtung
- 52: erster Federarm
- 54: zweiter Federarm
- 55: Steuergehäuse
- 56: erster Kontaktbereich
- 57: zweiter Kontaktbereich
- 58: Kontaktfläche
- 60: Aufnahmebereich
- 61: Leistungsschalter
- 62: erste Montagerichtung
- 64: zweite Montagerichtung
- 66: Längsachse
- 68: Ende
- 70: verjüngter Endbereich
- 72: Haltesteg
- 74: Ausnehmung
- 76: Führungsabschnitt
- 78: Führungsbereich
- 80: Kontaktvorsprung
- 82: erstes Element
- 84: zweites Element
- 86: erste Leiterplatte
- 88: zweite Leiterplatte
- 90: Leiterplatte
- 92: Stecker

## Patentansprüche

1. Leitungsweg (47) für Leistungsstrom oder Steuersignale, insbesondere einer elektrischen Heizvorrichtung (1), wobei in dem Leitungsweg (47) mindestens eine Leiterplatte (90, 86, 88), eine elektrisch mit der Leiterplatte (90, 86, 88) verbundene Kontaktfeder (48) und ein Kontaktstift (49) vorgesehen ist, der mit der Kontaktfeder (48) steckkontaktiert ist,
**dadurch gekennzeichnet,**
**dass** die Kontaktfeder (48) mit einem ersten Federarm (52) und einem zweiten Federarm (54) ausgebildet ist, die einen Aufnahmebereich (60) der Kontaktfeder (48) bilden, in dem der Kontaktstift (49) zumindest teilweise aufgenommen ist, wobei durch die Aufnahme des Kontaktstiftes (49) im Aufnahmebereich (60) eine elektrische Verbindung zwischen Kontaktfeder (48) und Kontaktstift (49) und eine mechanische Fixierung des Kontaktstiftes (49) in der Kontaktfeder (48) erreicht wird, wobei der Kontaktstift (49) eine Längsachse (66) aufweist, wobei die Kontaktfeder (48) in Richtung der Längsachse (66) und in einer ersten Montagerichtung (62) senkrecht zur Längsachse (66) offen ausgebildet ist, wobei die Federarme (52, 54) zur Fixierung des Kontaktstifts (49) vorgespannt ausgebildet sind, wobei die Kontaktfeder (48) an einem ersten Element (82) und der Kontaktstift (49) an einem zweiten Element (84) ausgebildet ist, wobei das erste Element (82) und das zweite Element (84) in mindestens einer der folgenden Konstellationen ausgebildet sind:
a. das erste Element (82) ist eine erste Leiterplatte (86) und das zweite Element (84) ist eine zweite Leiterplatte (88);
b. das erste Element (82) ist eine Leiterplatte (90) und das zweite Element (84) ist ein Stecker (92);
c. das erste Element (82) ist eine Leiterplatte (90) und das zweite Element ist eine Kontaktierungseinrichtung (50), über die mehrere Heizeinrichtungen (24) elektrisch miteinander zu einem Heizkreis gruppiert sind; und
d. das erste Element (82) ist die Kontaktierungseinrichtung (50) und das zweite Element (84) eine Leiterplatte (90).

2. Leitungsweg (47) nach Anspruch 1, **dadurch gekennzeichnet, dass** die Kontaktfeder (48) einen Führungsbereich (78) aufweist, der sich entgegengesetzt zur ersten Montagerichtung (62) vom Aufnahmebereich (60) weg erstreckt, der sich in Richtung auf den Aufnahmebereich (60) zur Führung des Kontaktstiftes (49) bei Einführung des Kontaktstiftes (49) in der ersten Montagerichtung (62) verjüngt.

3. Leitungsweg (47) nach Anspruch 1 oder 2, **dadurch gekennzeichnet, dass** die Kontaktfeder (48) mit dem ersten Element (82) verlötet ist.

4. Leitungsweg (47) nach einem der vorherigen Ansprüche, **dadurch gekennzeichnet, dass** die Kontaktfeder (48) mindestens einen Haltesteg (72) aufweist, der in eine entsprechende Ausnehmung (74) des ersten Elementes (50) eingreift.

5. Leitungsweg (47) nach Anspruch 4, **dadurch gekennzeichnet, dass** der Haltesteg (72) mit der Ausnehmung (74) verlötet ist.

6. Leitungsweg (47) nach einem der vorherigen Ansprüche, **dadurch gekennzeichnet, dass** der Kontaktbereich (56) rotationssymmetrisch zur Längsachse (66) ausgebildet ist.

7. Leitungsweg (47) nach einem der vorhergehenden Ansprüche, **dadurch gekennzeichnet, dass** der Kontaktstift (49) in Richtung der Längsachse (66) an einem Ende (68) einen sich verjüngenden Einführbereich (70) aufweist.

8. Leitungsweg (47) nach einem der vorhergehenden Ansprüche, **dadurch gekennzeichnet, dass** an den Federarmen (52, 54) Kontaktvorsprünge (80) ausgebildet sind, die an der Kontaktfläche (58) des Kontaktstiftes (49) anliegen.

9. Elektrische Heizvorrichtung (1), umfassend wenigstens einen Leitungsweg (47) nach einem der vorhergehenden Ansprüche.
